# EUROPEAN PATENT APPLICATION

(11) **EP 4 350 031 A1**
(43) Date of publication of application: **10.04.2024**
(21) Application number: 22810360.2
(22) Date of filing: 11.05.2022
(51) Int. Cl.: C23C 16/513, C23C 16/50, C23C 16/448, C23C 14/48, C09D 183/04, C23C 16/42, C23C 16/30, B05D 7/24, B05D 3/14, B05D 5/08

(54) **PLASMA POLYMERISATION COATING, PREPARATION METHOD, AND DEVICE**

(30) Priority: 26.05.2021 CN 202110580670
(71) Applicant: Jiangsu Favored Nanotechnology Co., Ltd., Wuxi, Jiangsu 214000 (CN)
(72) Inventor: ZONG, Jian, Wuxi, Jiangsu 214000 (CN)
(74) Representative: Mewburn Ellis LLP
(86) International application number: PCT/CN2022/092128
(87) International publication number: WO 2022/247633

(57) **Abstract**

Provided in the specific embodiments of the present invention are a plasma polymerisation coating, the plasma polymerisation coating being formed by the plasma deposition of a substrate in contact with an organosilane monomer having an aromatic group or epoxy group; the coating formed by plasma deposition containing said monomer can effectively improve the wear resistance of the coating.

## Description

This application claims the benefit of priority to Chinese Patent Application No. 202110580670.5, filed on May 26, 2021 with China National Intellectual Property Administration, and entitled "PLASMA POLYMERISATION COATING, PREPARATION METHOD, AND DEVICE", the entire disclosure of which is incorporated herein by reference.

### TECHNICAL FIELD

The present disclosure relates to the field of plasma chemistry, and particularly, to a plasma polymerized coating, a method for preparing the same, and a device including the same.

### BACKGROUND

Plasma enhanced chemical vapor deposition (PECVD) process ionizes a gas containing a thin coating components in virtue of microwave or radio frequency, etc., to form plasma locally, which is very chemically active and prone to reaction, so as to deposit on a substrate a desired waterproof protective nano-coating that is uniform, prepared at a low temperature, has a thin thickness, and is small in stress, with almost no damage to a surface of the substrate and almost no effect on the performance of the substrate.

It has been increasingly applied to form a waterproof protective coating on the surface of the substrate through PECVD. Currently, research on the waterproof protective coating mainly focuses on how to improve its waterproof performance and how to improve the bonding force between the coating and the substrate. For the waterproof protective coating formed by PECVD, when scratched or rubbed by external force, it is easy to be damaged to affect its protective performance due to thin thickness thereof, however, there is no relevant report on how to improve the wear resistance of the coating itself.

### SUMMARY

Embodiments of the present disclosure provides a plasma polymerized coating with improved wear resistance, a method for preparing the same, and a device including the same. The specific solutions are as follows.

A plasma polymerized coating formed by reacting and depositing plasma of a reactive monomer on a substrate exposed to the plasma,
wherein the reactive monomer includes a monomer having a structure represented by formula (1), 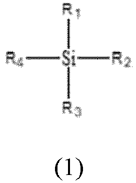
in formula (1), R₁, R₂, R₃ and R₄ are each independently selected from a group consisting of a hydrogen atom, halogen atoms, substituted or unsubstituted C₁-C₂₀ hydrocarbyl groups, substituted or unsubstituted C₁-C₂₀ alkoxy groups, and C₄-C₂₀ aromatic groups; and
wherein at least one of R₁, R₂, R₃ and R₄ contains an epoxy group or is a C₄-C₂₀ aromatic group.

Optionally, R₁, R₂, R₃ and R₄ are each independently selected from a group consisting of a hydrogen atom, halogen atoms, C₁-C₂₀ hydrocarbyl groups, C₁-C₂₀ hydrocarbyl groups substituted with an epoxy structure, C₁-C₂₀ alkoxy groups, C₁-C₂₀ alkoxy groups substituted with an epoxy structure, and C₆-C₂₀ aromatic groups.

Optionally, R₁, R₂, R₃ and R₄ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, and C₆-C₂₀ aromatic groups, wherein at least one of R₁, R₂, R₃ and R₄ is a C₆-C₂₀ aromatic group.

Optionally, the aromatic group is phenyl.

Optionally, the monomer having the structure represented by formula (1) is one or more selected from a group consisting of phenyltrichlorosilane, diphenylchlorosilane, diphenyldichlorosilane, triphenylvinylsilane, diphenyldivinylsilane, diphenyldimethoxysilane, and phenyltrimethoxysilane.

Optionally, R₁, R₂, R₃ and R₄ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, C₂-C₁₀ epoxyalkoxyhydrocarbyl groups, and C₂-C₁₀ epoxyhydrocarbyl groups, wherein at least one of R₁, R₂, R₃ and R₄ is a C₂-C₁₀ epoxyalkoxyhydrocarbyl group or a C₂-C₁₀ epoxyhydrocarbyl group.

Optionally, the epoxy is a cycloaliphatic epoxy.

Optionally, the monomer having the structure represented by formula (1) is one or more selected from a group consisting of 3-(2,3-epoxypropoxy)propylmethyldimethoxysilane, 3-(2,3-epoxypropoxy)propyltrimethoxysilane, β-(3,4-epoxycyclohexyl)-ethyltrimethoxysilane, and 2-(3,4-epoxycyclohexyl)ethyltriethoxysilane.

Optionally, the reactive monomer further includes one or more of fluorohydrocarbons, fluoroacrylates and fluorosilanes.

Optionally, the fluoroacrylates have a structure represented by formula (2), 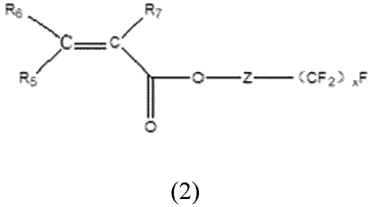 wherein Z is a linker, R₅, R₆ and R₇ are each independently selected from a group consisting of a hydrogen atom, halogen atoms, C₁-C₁₀ hydrocarbyl groups, and C₁-C₁₀ hydrocarbyl groups substituted with a halogen atom, and x is an integer of 1-20.

Optionally, Z is a linking bond, a C₁-C₄ alkylene group, or a C₁-C₄ alkylene group with a substituent, and x is above 4.

Optionally, R₅, R₆ and R₇ are each independently selected from a group consisting of a hydrogen atom and a methyl group.

Optionally, the fluoroacrylates are one or more selected from a group consisting of 3-(perfluoro-5-methylhexyl)-2-hydroxypropyl methacrylate, 2-(perfluorodecyl)ethyl methacrylate, 2-(perfluorohexyl)ethyl methacrylate, 2-(perfluorododecyl)ethyl acrylate, 2-perfluorooctyl ethyl acrylate, 1H,1H,2H,2H-perfluorooctyl acrylate, 2-(perfluorobutyl)ethyl acrylate, and (perfluorocyclohexyl) methacrylate.

Optionally, the substrate is a metal, a plastic, a fabric, glass, an electrical component, an optical instrument, or an electrical part.

Optionally, the substrate is a glass screen.

A method for preparing any of the plasma polymerized coatings above, which includes:
providing a substrate to place it in a plasma reactor; and introducing a vaporized reactive monomer into the plasma reactor, and performing plasma discharge, so as to carry out plasma polymerization on a surface of the substrate to form a coating.

Optionally, the plasma is pulsed plasma.

Optionally, the pulsed plasma is generated by applying impulsive voltage discharge with a pulse power of 1 0W-300W and a pulse duty factor of 0.1%-80%, for a plasma discharge time of 100 seconds-36000 seconds.

A device having any of the above-mentioned plasma polymerized coatings on at least a part of the surface of the device.

The plasma polymerized coating of the present disclosure is a plasma polymerized coating formed from a monomer including organosilane with an aromatic group or an epoxy group, and may have effectively improved wear resistance.

### DETAILED DESCRIPTION

A plasma polymerized coating according to the embodiments of the present disclosure is formed by reacting and depositing plasma of a reactive monomer on a substrate exposed to the plasma,
wherein the reactive monomer may be a monomer has a structure represented by formula (1), 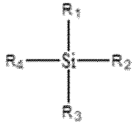 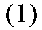
in formula (1), R₁, R₂, R₃ and R₄ are each independently selected from a group consisting of a hydrogen atom, halogen atoms, substituted or unsubstituted C₁-C₂₀ hydrocarbyl groups, substituted or unsubstituted C₁-C₂₀ alkoxy groups, and C₄-C₂₀ aromatic groups; and
wherein at least one of R₁, R₂, R₃ and R₄ contains an epoxy group or is a C₄-C₂₀ aromatic group.

The inventor of the present disclosure has found thorough research that, the plasma polymerized coating formed from the monomer including organosilane with an aromatic group or an epoxy group represented by formula (1) may have effectively improved wear resistance, which is probably because the epoxy group with high reactivity is prone to form a network structure due to the rigid effect of the aromatic ring in the aromatic group.

For the plasma polymerized coating according to the embodiments of the present disclosure, the hydrocarbyl groups may be alkyl groups, alkenyl groups or alkynyl groups, or may be cycloaliphatic hydrocarbyl groups or aryl hydrocarbyl groups; and the alkoxy groups may be alkoxy groups, alkenyloxy groups or alkynyloxy groups, or may be cycloaliphatic alkoxy groups or alkyloxy groups.

For the plasma polymerized coating according to the embodiments of the present disclosure, the substituent for substitution may be, for example, a halogen atom, an epoxy group, a nitro group, a cyano group, a sulfonic acid group, an amino group, a carboxyl group, a hydroxyl group, a sulfhydryl group, a hydrocarbyl group, an alkoxy group, or an acyl group, etc., and may be one or two or more.

For the plasma polymerized coating according to the embodiments of the present disclosure, the aromatic groups are aryl groups or heteroaryl groups.

For the plasma polymerized coating according to some embodiments of the present disclosure, R₁, R₂, R₃ and R₄ are each independently selected from a group consisting of a hydrogen atom, halogen atoms, C₁-C₂₀ hydrocarbyl groups, C₁-C₂₀ hydrocarbyl groups substituted with an epoxy structure, C₁-C₂₀ alkoxy groups, C₁-C₂₀ alkoxy groups substituted with an epoxy structure, and C₆-C₂₀ aromatic groups.

For the plasma polymerized coating according to some embodiments of the present disclosure, R₁, R₂, R₃ and R₄ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, and C₆-C₂₀ aromatic groups, wherein at least one of R₁, R₂, R₃ and R₄ is a C₆-C₂₀ aromatic group. As an example, the alkyl groups may be, for example, methyl, ethyl, propyl, butyl, isopropyl, or the like; the alkoxy groups may be, for example, methoxy, ethoxy, propoxy, butoxy, isopropoxy, or the like; the alkenyl groups may be, for example, vinyl, propenyl, butenyl, or the like; the alkenyloxy groups may be, for example, 2-(allyloxy); and the aromatic groups may be, for example, phenyl, p-methylphenyl, biphenyl, or the like. More specifically, the monomer having the structure represented by formula (1) is one or more selected from a group consisting of phenyltrichlorosilane (CAS: 98-13-5), diphenylchlorosilane (CAS: 1631-83-0), diphenyldichlorosilane (CAS: 80-10-4), triphenylvinylsilane (CAS: 18666-68-7), diphenyldivinylsilane (CAS: 17937-68-7), diphenyldimethoxysilane (CAS: 6843-66-9), and phenyltrimethoxysilane (CAS: 2996-92-1).

For the plasma polymerized coating according to some embodiments of the present disclosure, R₁, R₂, R₃ and R₄ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, C₂-C₁₀ epoxyalkoxyhydrocarbyl groups, and C₂-C₁₀ epoxyhydrocarbyl groups, wherein at least one of R₁, R₂, R₃ and R₄ is a C₂-C₁₀ epoxyalkoxyhydrocarbyl group or a C₂-C₁₀ epoxyhydrocarbyl group. As an example, the alkyl groups may be, for example, methyl, ethyl, propyl, butyl, isopropyl, or the like; the alkoxy groups may be, for example, methoxy, ethoxy, propoxy, butoxy, isopropoxy, or the like; the alkenyl groups may be, for example, vinyl, propenyl, butenyl, or the like; the alkenyloxy groups may be, for example, 2-(allyloxy); the epoxyalkoxyhydrocarbyl groups may be, for example, (2,3-epoxypropoxy)ethyl, (2,3-epoxypropoxy)propyl, (3,4-epoxybutoxy)ethyl, (3,4-epoxybutoxy)propyl, or the like; and the epoxyhydrocarbyl groups may be, for example, 2,3-epoxypropyl, 3,4-epoxyethyl, 3,4-epoxybutyl, 3,4-epoxycyclohexyl, or the like. More specifically, the monomer having the structure represented by formula (1) is one or more selected from a group consisting of 3-(2,3-epoxypropoxy)propylmethyldimethoxysilane (CAS: 65799-47-5), 3-(2,3-epoxypropoxy)propyltrimethoxysilane (CAS: 2530-83-8), β-(3,4-epoxycyclohexyl)-ethyltrimethoxysilane (CAS: 3388-04-3), and 2-(3,4-epoxycyclohexyl)ethyltriethoxysilane (CAS: 10217-34-2). According to some specific embodiments, the epoxy is a cycloaliphatic epoxy, such as 3,4-epoxycyclohexyl, so that a better effect of improving wear resistance may be caused.

For the plasma polymerized coating according to some embodiments of the present disclosure, the reactive monomer further includes one or more fluorine-containing monomers of fluorohydrocarbons, fluoroacrylates and fluorosilanes. According to some specific embodiments, the fluoroacrylates have a structure represented by formula (2), 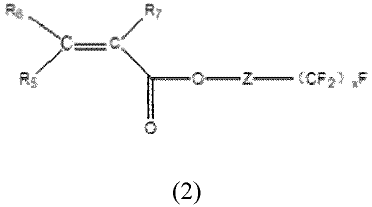 wherein Z is a linker, R₅, R₆ and R₇ are each independently selected from a group consisting of a hydrogen atom, halogen atoms, C₁-C₁₀ hydrocarbyl groups, and C₁-C₁₀ hydrocarbyl groups substituted with a halogen atom, and x is an integer of 1-20.

For the plasma polymerized coating according to the embodiments of the present disclosure, Z is a linker for connecting an ester bond and a perfluoroalkyl group. According to some specific embodiments, Z is a linking bond, a C₁-C₄ alkylene group, or a C₁-C₄ alkylene group with a substituent, and x is above 4. The alkylene group may include a linear alkyl group, such as methylene, ethylidene, propylidene, butylidene, or the like, or an alkylene group containing a branched chain, such as isopropylidene, isobutylidene, or the like. The substituent may include, for example, a halogen atom, a hydroxyl group, a carboxyl group, an ester group, or the like.

For the plasma polymerized coating according to the embodiments of the present disclosure, when the reactive monomer simultaneously includes a fluoroacrylate monomer having the structure represented by formula (2) and a monomer having the structure represented by formula (1), in particular, when x is above 4, further is above 6, for example, when x is specifically 6, 7, 8, 9, 10, 11, 12, 13, 14, 15, 16, 17, 18, 19 or 20, the plasma polymerized coating may still maintain excellent waterproof and oilproof performance after being repeatedly rubbed.

For the plasma polymerized coating according to the embodiments of the present disclosure, as a specific and nonrestrictive example, the fluoroacrylate is one or more selected from a group consisting of 3-(perfluoro-5-methylhexyl)-2-hydroxypropyl methacrylate (CAS: 16083-81-1), 2-(perfluorodecyl)ethyl methacrylate (CAS: 2144-54-9), 2-(perfluorohexyl)ethyl methacrylate (CAS: 2144-53-8), 2-(perfluorododecyl)ethyl acrylate (CAS: 34395-24-9), 2-perfluorooctyl ethyl acrylate (CAS: 27905-45-9), 1H,1H,2H,2H-perfluorooctyl acrylate (CAS: 17527-29-6), 2-(perfluorobutyl)ethyl acrylate (CAS: 52591-27-2), and (perfluorocyclohexyl) methacrylate (CAS: 40677-94-9).

For the plasma polymerized coating according to some embodiments of the present disclosure, the substrate is made of metal, such as, iron, magnesium, aluminum, copper or an alloy thereof. According to some other specific embodiments, the substrate is a variety of plastics, fabrics, glass, electrical components or optical instruments, and the like. Specifically, the electrical components may be printed circuit boards (PCBs), electronic products, or semifinished electronic assembly products, or the like. When the substrate is an electronic product, it is exemplarily, but not limited to, mobile phones, tablets, keyboards, e-readers, wearable devices, displays, and the like. The substrate may also be any one suitable electrical part of the electrical components. Specifically, the electrical part may be a resistor, a capacitor, a transistor, a diode, an amplifier, a relay, a transformer, a battery, a fuse, an integrated circuit, a switch, a LED, a LED display, a piezoelectric element, an optoelectronic part, or an antenna, or an oscillator, or the like.

For the plasma polymerized coating according to some embodiments of the present disclosure, the substrate is a glass screen, in particular a mobile phone screen. Smart phone has been popularized at present, and a lot of mobile phone manufacturers will choose glass coated with an anti-fingerprint coating as a mobile phone screen in terms of the problem of waterproofing and anti-fingerprint in mobile phone. Currently, there are two mainstream anti-fingerprint processes: one is the physical vapor deposition process, and the other is the wet spraying process, which are relatively expensive and have relatively harsh experimental conditions, such that some cheap low-end mobile phones do not undergo the anti-fingerprint process in the screen, which greatly reduces the waterproof and oilproof performance of the mobile phones during use. For the plasma polymerized coating according to the embodiments of the present disclosure, the coating is more easily prepared, is uniform, has a thin thickness and small stress, and leads to almost no damage to the surface of the substrate and almost no effect on the performance of the substrate, and simultaneously, has excellent wear-resistant performance, and is particularly applicable as a protective coating for a glass screen of mobile phone, etc.

The plasma polymerized coating according to some embodiments of the present disclosure is formed by depositing plasma of the monomer having the structure represented by formula (1) and the monomer of the fluoroacrylates on the substrate exposed to the plasma. According to some specific embodiments, the molar ratio of the monomer having the structure represented by formula (1) to the monomer of the fluoroacrylates may be 3:10-10:3, and specifically, may be, for example, 3:10, 4:10, 5:10, 6:10, 7:10, 8:10, 9:10, 10:10, 10:9, 10:8, 10:7, 10:6, 10:5, 10:4, or 10:3, or the like. According to some other specific embodiments, the coating may also be formed by depositing plasma of the monomer having the structure represented by formula (1) and other monomers on the substrate exposed to the plasma according to actual needs.

The embodiments of the present disclosure further provide a method for preparing any one of the above plasma polymerized coatings, which includes:
providing a substrate to place it in a plasma reactor; and introducing a vaporized reactive monomer into the plasma reactor, and performing plasma discharge, so as to carry out plasma polymerization on a surface of the substrate to form a coating.

The method for preparing the plasma polymerized coating according to the embodiments of the present disclosure provides a method for increasing wear resistance of the plasma polymerized coating.

For the method for preparing the plasma polymerized coating according to the embodiments of the present disclosure, the monomer and the substrate are as described above.

For some substrates, such as mobile phone screens or circuit boards in the method for preparing the plasma polymerized coating according to some embodiments of the present disclosure, in order to further enhance the binding force between the plasma polymerized coating and the substrate, the substrate may be pretreated with continuous plasma before coating. Specifically, the substrate may be pretreated, for example, in an inert gas atmosphere, with a plasma discharge power of 20 W-500 W, in a continuous discharge mode, for a continuous discharge time of 1 min~60 min, or may be pretreated with heat, oxygen, or high-energy radiation, or the like.

For the method for preparing the plasma polymerized coating according to some embodiments of the present disclosure, the plasma is plasma excited by a continuous wave. According to some other specific embodiments, the plasma is plasma excited by pulse at a flow rate of the monomer of 50 µL/min -500 µL/min, for example, of 100 µL/min, 200 µL/min, 300 µL/min, or 400 µL/min, and the like. The reactor may have a temperature controlled at 20°C-80°C, for example, at 20°C, 30°C, 40°C, 50°C, 60°C, 70°C, or 80°C, or the like. The monomer may be vaporized at a temperature of 50°C-180°C, for example, at 50°C, 60°C, 70°C, 80°C, 90°C, 100°C, 110°C, 120°C, 130°C, 140°C, 150°C, 160°C, 170°C, 180°C, and the like, under a vacuum condition. The pulse plasma is generated by applying pulse voltage discharge with a pulse power of 10 W-300 W, for example, of 10 W, 20 W, 30 W, 50 W, 70 W, 80 W, 100 W, 120 W, 140 W, 160 W, 180 W, 190 W, 200 W, 210 W, 220 W, 230 W, 240 W, 250 W, 260 W, 270 W, 280 W, 290 W, or 300 W, or the like, and a pulse duty factor of 0.1%-85%, for example, of 0.1%, 0.5%, 1%, 5%, 10%, 15%, 20%, 25%, 30%, 35%, 40%, 45%, 50%, 55%, 60%, 65%, 70%, 75%, 80%, or 85%, or the like, for a plasma discharge time of 100 seconds-36000 seconds, for example, of 100 seconds, 500 seconds, 1000 seconds, 1800 seconds, 2000 seconds, 1000 seconds, 2000 seconds, 3000 seconds, 4000 seconds, 5000 seconds, 6000 seconds, 7000 seconds, 7200 seconds, 10800 seconds, 14400 seconds, 18000 seconds, 21600 seconds, 25200 seconds, 28800 seconds, 32400 seconds, or 36000 seconds, or the like.

For the method for preparing the plasma polymerized coating according to some embodiments of the present disclosure, mode of the plasma discharge may be various existing discharge modes, specifically, may be electrodeless discharge (such as radio frequency inductive coupling discharge, microwave discharge), single electrode discharge (such as corona discharge, plasma jet formed by unipolar discharge), double electrode discharge (such as dielectric barrier discharge, radio frequency glow discharge with bare electrode), and multi-electrode discharge (such as the discharge with a floating electrode as the third electrode).

The embodiments of the present disclosure further provide a device having any of the above-mentioned plasma polymerized coatings on at least a part of a surface of the device. According to some specific embodiments, part or all of the surface of the device is deposited with the plasma polymerized coating described above.

The present disclosure will be further described below by specific examples.

### Example

### Example 1

### Solution 1.

A mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1.5%. Thereafter, a monomer of β-(3,4-epoxycyclohexyl)-ethyltrimethoxysilane and a monomer of 2-perfluorooctylethyl acrylate were vaporized at a temperature of 180°C and then introduced at a flow rate of 75 µL/min for the monomer of β-(3,4-epoxycyclohexyl)-ethyltrimethoxysilane and a flow rate of 75 µL/min for the monomer of 2-perfluorooctylethyl acrylate into the chamber, for a reaction time of 5400 seconds, for plasma chemical vapor deposition. And, when the discharge was over, compressed air was introduced to restore the chamber to normal pressure, to open the chamber and take out the mobile phone screen.

### Solution 2.

Another mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1.5%. Thereafter, a monomer of 2-perfluorooctylethyl acrylate was vaporized at a temperature of 180°C and then introduced at a flow rate of 150 µL/min into the chamber, for a reaction time of 5400 seconds, for plasma chemical vapor deposition. And, when the discharge was over, compressed air was introduced to restore the chamber to normal pressure, to open the chamber and take out the mobile phone screen.

### Solution 3.

A mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1.5%. Thereafter, a monomer of 3-(2,3-epoxypropoxy)propyltrimethoxysilane and a monomer of 2-perfluorooctylethyl acrylate were vaporized at a temperature of 180°C and then introduced at a flow rate of 75 µL/min for the monomer of 3-(2,3-epoxypropoxy)propyltrimethoxysilane and a flow rate of 75 µL/min for the monomer of 2-perfluorooctylethyl acrylate into the chamber, for a reaction time of 5400 seconds, for plasma chemical vapor deposition. And, when the discharge was over, compressed air was introduced to restore the chamber to normal pressure, to open the chamber and take out the mobile phone screen.

### Solution 4.

A mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1.5%. Thereafter, a monomer of tetramethoxysilane and a monomer of 2-perfluorooctylethyl acrylate were vaporized at a temperature of 180°C and then introduced at a flow rate of 75 µL/min for the monomer of tetramethoxysilane and a flow rate of 75 µL/min for the monomer of 2-perfluorooctylethyl acrylate into the chamber, for a reaction time of 5400 seconds, for plasma chemical vapor deposition. And, when the discharge was over, compressed air was introduced to restore the chamber to normal pressure, to open the chamber and take out the mobile phone screen.

Wear resistance was tested on the mobile phone screens in solutions 1, 2, 3 and 4 by a rub tester with a friction material of dust-free cloth at a load of 100 g and a rotation rate of 50 r/min. Water contact angle and n-hexadecane oil contact angle were recorded every 100 times of rubbing.

The tested results are as follows:

| Mobile phone screens | Wear resistance (wca/oca) | | | |
|---|---|---|---|---|
| | 0 time | 100 times | 500 times | 1000 times |
| Solution 1 | 120°/80° | 118°/79° | 112°/75° | 108°/72° |
| Solution 2 | 125°/81° | 110°/75° | 75°/60° | 60°/52° |
| Solution 3 | 121°/81° | 115°/78° | 108°/72° | 102°/65° |
| Solution 4 | 122°/80° | 113°/76° | 81°/63° | 67°/56° |

It can be seen from the results in the above table that, the plasma polymerized coating of the monomer containing the organosilicon monomer with a cycloaliphatic epoxy group of β-(3,4-epoxycyclohexyl)-ethyltrimethoxysilane in solution 1 has the best wear resistance, that is, a water contact angle maintained at 108° and a n-hexadecane oil contact angle maintained at 72° after 1000 times of rubbing. The plasma polymerized coating of the monomer containing the organosilicon monomer with a hydrocarbylepoxy group of 3-(2,3-epoxypropoxy)propyltrimethoxysilane in solution 3 has good wear resistance, that is, water contact angle maintained at 102° and n-hexadecane oil contact angle maintained at 65° after 1000 times of rubbing, which are, however, slightly worse than those in solution 1. The plasma polymerized coatings of a monomer containing no organosilicon monomer or containing non-epoxy silicone monomer of tetramethoxysilane in solutions 2 and 4 have relatively poor wear resistance, that is, water contact angles maintained only at 60° and 67° and n-hexadecane oil contact angles maintained only at 52° and 56°, respectively, after 1000 times of rubbing.

### Example 2

### Solution 1.

A mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1%. Thereafter, a monomer of phenyltrimethoxysilane and a monomer of 1H, 1H,2H,2H-perfluorooctyl acrylate were vaporized at a temperature of 145°C and then introduced at a flow rate of 80 µL/min for the monomer of phenyltrimethoxysilane and a flow rate of 80 µL/min for the monomer of 1H,1H,2H,2H-perfluorooctyl acrylate into the chamber, for a reaction time of 6000 seconds, for plasma chemical vapor deposition. And, when the discharge was over, compressed air was introduced to restore the chamber to normal pressure, to open the chamber and take out the mobile phone screen.

### Solution 2.

Another mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1%. Thereafter, a monomer of 1H,1H,2H,2H-perfluorooctyl acrylate was vaporized at a temperature of 145°C and then introduced at a flow rate of 160 µL/min into the chamber, for a reaction time of 6000 seconds, for plasma chemical vapor deposition. And, when the discharge was over, compressed air was introduced to restore the chamber to normal pressure, to open the chamber and take out the mobile phone screen.

### Solution 3.

A mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1%. Thereafter, a monomer of tetramethoxysilane and a monomer of 1H,1H,2H,2H-perfluorooctyl acrylate were vaporized at a temperature of 145°C and then introduced at a flow rate of 80 µL/min for the monomer of tetramethoxysilane and a flow rate of 80 µL/min for the monomer of 1H,1H,2H,2H-perfluorooctyl acrylate into the chamber, for a reaction time of 6000 seconds, for plasma chemical vapor deposition. And, when the discharge was over, compressed air was introduced to restore the chamber to normal pressure, to open the chamber and take out the mobile phone screen.

Wear resistance was tested on the mobile phone screens in solutions 1, 2 and 3 by a rub tester with a friction material of dust-free cloth at a load of 500 g and a rotation rate of 50 r/min. Water contact angle and n-hexadecane oil contact angle were recorded every 50 times of rubbing.

The tested results are as follows:

| Mobile phone screens | Wear resistance (wca/oca) | | |
|---|---|---|---|
| | 0 time | 50 times | 500 times |
| Solution 1 | 120°/80° | 117°/78° | 100°/68° |
| Solution 2 | 121°/81° | 57°/34° | / |
| Solution 3 | 120°/81° | 92°/58° | 55°/36° |

It can be seen from the results in the above table that, the plasma polymerized coating of the monomer containing the organosilicon monomer with an aryl group of phenyltrimethoxysilane in solution 1 has good wear resistance, that is, water contact angle maintained at 100° and n-hexadecane oil contact angle maintained at 68° after 500 times of rubbing. The plasma polymerized coatings of the monomer containing no organosilicon monomer or containing the organosilicon monomer without aryl group of tetramethoxysilane in solutions 2 and 3 have relatively poor wear resistance, that is, the plasma polymerized coating of the monomer without organosilicon monomer has been directly worn after 500 times of friction, and the plasma polymerized coating of the monomer containing the organosilicon monomer without aryl group of tetramethoxysilane has a water contact angle maintained only at 55°and a n-hexadecane oil contact angle maintained only at 36° after 500 times of rubbing.

### Example 3

### Solution 1.

A mobile phone screen was placed in a plasma chamber, which was then continuously evacuated to 5 millitorr, and introduced with helium at a flow rate of 40 sccm, followed by starting plasma discharge with a pulse power of 200 W and a duty factor of 1.5%. Thereafter, a monomer of diphenyldimethoxysilane and a monomer of 2-perfluorooctylethyl acrylate were vaporized at a temperature of 180°C and then introduced at a flow rate of 75 µL/min for the monomer of diphenyldimethoxysilane and a flow rate of 75 µL/min for the monomer of 2-perfluorooctylethyl acrylate into the chamber, for a reaction time of 1800 seconds, for plasma chemical vapor deposition. And, when the discharge was over, compressed air was introduced to restore the chamber to normal pressure, to open the chamber and take out the mobile phone screen.

### Solution 2.

Another mobile phone screen was placed in a plasma chamber, which was then continuously evacuated to 5 millitorr, and introduced with helium at a flow rate of 40 sccm, followed by starting plasma discharge with a pulse power of 200 W and a duty factor of 1.5%. Thereafter, a monomer of 2-perfluorooctylethyl acrylate was vaporized at a temperature of 180°C and then introduced at a flow rate of 150 µL/min into the chamber, for a reaction time of 1800 seconds, for plasma chemical vapor deposition. And, when the discharge was over, compressed air was introduced to restore the chamber to normal pressure, to open the chamber and take out the mobile phone screen.

Wear resistance was tested on the mobile phone screens in solutions 1 and 2 by a rub tester with a friction material of dust-free cloth at a load of 100 g and a rotation rate of 50 r/min. Water contact angle and n-hexadecane oil contact angle were recorded every 10 times of rubbing.

The tested results are as follows:

| Mobile phone screens | Wear resistance (wca/oca) | | |
|---|---|---|---|
| | 0 time | 10 times | 100 times |
| Solution 1 | 120°/80° | 110°/75° | 102°/69° |
| Solution 2 | 125°/82° | 30°/40° | / |

It can be seen from the results in the above table that, the plasma polymerized coating of the monomer containing the organosilicon monomer with an aryl group of diphenyldimethoxysilane in solution 1 has good wear resistance, that is, water contact angle maintained at 102° and n-hexadecane oil contact angle maintained at 69° after 100 times of rubbing. The plasma polymerized coating of the monomer without the organosilicon monomer in solution 2 has been directly worn after 100 times of rubbing.

### Example 4

### Solution 1.

A mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1.5%. Thereafter, a monomer of β-(3,4-epoxycyclohexyl)-ethyltrimethoxysilane, a monomer of phenyltrimethoxysilane, and a monomer of 1H,1H,2H,2H-perfluorooctyl acrylate were vaporized at a temperature of 180°C and then introduced at a flow rate of 45 µL/min for the monomer of β-(3,4-epoxycyclohexyl)-ethyltrimethoxysilane, a flow rate of 45 µL/min for the monomer of phenyltrimethoxysilane, and a flow rate of 60 µL/min for the monomer of 1H,1H,2H,2H-perfluorooctyl acrylate into the chamber, for a reaction time of 5000 seconds, for plasma chemical vapor deposition. And, when the discharge was over, compressed air was introduced to restore the chamber to normal pressure, to open the chamber and take out the mobile phone screen.

### Solution 2.

Another mobile phone screen was placed in a plasma chamber, which was then continuously evacuated to 5 millitorr, and introduced with helium at a flow rate of 40 sccm, followed by starting plasma discharge with a pulse power of 180 W and a duty factor of 1.5%. Thereafter, a monomer of 1H,1H,2H,2H-perfluorooctyl acrylate was vaporized at a temperature of 180°C and then introduced at a flow rate of 150 µL/min into the chamber, for a reaction time of 5000 seconds, for plasma chemical vapor deposition. And, when the discharge was over, compressed air was introduced to restore the chamber to normal pressure, to open the chamber and take out the mobile phone screen.

Wear resistance was tested on the mobile phone screens in solutions 1 and 2 by a rub tester with a friction material of dust-free cloth at a load of 100 g and a rotation rate of 50 r/min. Water contact angle and n-hexadecane oil contact angle were recorded every 100 times of rubbing.

The tested results are as follows:

| Mobile phone screens | Wear resistance (wca/oca) | | | |
|---|---|---|---|---|
| | 0 time | 100 times | 1000 times | 2000 times |
| Solution 1 | 120°/80° | 118°/78° | 113°/72° | 105°/69° |
| Solution 2 | 121°/81° | 110°/75° | 30°/35° | / |

It can be seen from the results in the above table that, the plasma polymerized coating of the monomer containing the organosilicon monomer with cycloaliphatic epoxy group of β-(3,4-epoxycyclohexyl)-ethyltrimethoxysilane and the organosilicon monomer with a phenyl group of phenyltrimethoxysilane in solution 1 has good wear resistance, that is, the water contact angle maintained at 105° and the n-hexadecane oil contact angle maintained at 69° after 2000 times of rubbing. The plasma polymerized coating of the monomer containing no organosilicon monomer in solution 2 has been directly worn after 2000 times of rubbing.

### Example 5

### Solution 1.

An iron sheet (30*20*2mm) was placed in a plasma chamber, which was then continuously evacuated to 5 millitorr, and introduced with helium at a flow rate of 40 sccm, followed by starting plasma discharge with a pulse power of 180 W and a duty factor of 3%. Thereafter, a monomer of β-(3,4-epoxycyclohexyl)-ethyltrimethoxysilane and a monomer of 2-perfluorooctylethyl acrylate were vaporized at a temperature of 180°C and then introduced at a flow rate of 100 µL/min for the monomer of β-(3,4-epoxycyclohexyl)-ethyltrimethoxysilane and a flow rate of 100 µL/min for the monomer of 2-perfluorooctylethyl acrylate into the chamber, for a reaction time of 3600 seconds, for plasma chemical vapor deposition. And, when the discharge was over, compressed air was introduced to restore the chamber to normal pressure, to open the chamber and take out the iron sheet.

### Solution 2.

Another iron sheet (30*20*2mm) was placed in a plasma chamber, which was then continuously evacuated to 5 millitorr, and introduced with helium at a flow rate of 40 sccm, followed by starting plasma discharge with a pulse power of 180 W and a duty factor of 3%. Thereafter, a monomer of 2-perfluorooctylethyl acrylate was vaporized at a temperature of 180°C and then introduced at a flow rate of 200 µL/min into the chamber, for a reaction time of 3600 seconds, for plasma chemical vapor deposition. And, when the discharge was over, compressed air was introduced to restore the chamber to normal pressure, to open the chamber and take out the iron sheet.

Wear resistance was tested on the iron sheets in solutions 1 and 2 by a rub tester with a friction material of dust-free cloth at a load of 100 g and a rotation rate of 50 r/min. Water contact angle and n-hexadecane oil contact angle were recorded every 100 times of rubbing.

The tested results are as follows:

| Iron sheets | Wear resistance (wca/oca) | | |
|---|---|---|---|
| | 0 time | 100 times | 500 times |
| Solution 1 | 120°/80° | 115°/75° | 106°/69° |
| Solution 2 | 125°/82° | 102°/70° | 52°/40° |

Although the present disclosure is disclosed as above, the disclosure is not limited hereto. Various changes and modifications may be made by those skilled in the art without departing from the spirit and scope of the present disclosure. Thus, the scope of protection of the present disclosure shall be subject to the scope defined by the claims.

## Claims

1. A plasma polymerized coating, **characterized by** being formed by reacting and depositing plasma of a reactive monomer on a substrate exposed to the plasma,
wherein the reactive monomer comprises a monomer having a structure represented by formula (1), 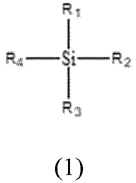
in formula (1), R₁, R₂, R₃ and R₄ are each independently selected from a group consisting of a hydrogen atom, halogen atoms, substituted or unsubstituted C₁-C₂₀ hydrocarbyl groups, substituted or unsubstituted C₁-C₂₀ alkoxy groups, and C₄-C₂₀ aromatic groups; and
wherein at least one of R₁, R₂, R₃ and R₄ contains an epoxy group or is a C₄-C₂₀ aromatic group.

2. The plasma polymerized coating according to claim 1, **characterized in that** R₁, R₂, R₃ and R₄ are each independently selected from a group consisting of a hydrogen atom, halogen atoms, C₁-C₂₀ hydrocarbyl groups, C₁-C₂₀ hydrocarbyl groups substituted with an epoxy structure, C₁-C₂₀ alkoxy groups, C₁-C₂₀ alkoxy groups substituted with an epoxy structure, and C₆-C₂₀ aromatic groups.

3. The plasma polymerized coating according to claim 2, **characterized in that** R₁, R₂, R₃ and R₄ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, and C₆-C₂₀ aromatic groups, wherein at least one of R₁, R₂, R₃ and R₄ is a C₆-C₂₀ aromatic group.

4. The plasma polymerized coating according to claim 3, **characterized in that** the aromatic group is phenyl.

5. The plasma polymerized coating according to claim 4, **characterized in that** the monomer having the structure represented by formula (1) is one or more selected from a group consisting of phenyltrichlorosilane, diphenylchlorosilane, diphenyldichlorosilane, triphenylvinylsilane, diphenyldivinylsilane, diphenyldimethoxysilane, and phenyltrimethoxysilane.

6. The plasma polymerized coating according to claim 2, **characterized in that** R₁, R₂, R₃ and R₄ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, C₂-C₁₀ epoxyalkoxyhydrocarbyl groups, and C₂-C₁₀ epoxyhydrocarbyl groups, wherein at least one of R₁, R₂, R₃ and R₄ is a C₂-C₁₀ epoxyalkoxyhydrocarbyl group or a C₂-C₁₀ epoxyhydrocarbyl group.

7. The plasma polymerized coating according to claim 6, **characterized in that** the epoxy is cycloaliphatic epoxy.

8. The plasma polymerized coating according to claim 6, **characterized in that** the monomer having the structure represented by formula (1) is one or more selected from a group consisting of 3-(2,3-epoxypropoxy)propylmethyldimethoxysilane, 3-(2,3-epoxypropoxy)propyltrimethoxysilane, β-(3,4-epoxycyclohexyl)-ethyltrimethoxysilane, and 2-(3,4-epoxycyclohexyl)ethyltriethoxysilane.

9. The plasma polymerized coating according to claim 1, **characterized in that** the reactive monomer further includes one or more of fluorohydrocarbons, fluoroacrylates and fluorosilanes.

10. The plasma polymerized coating according to claim 9, **characterized in that** the fluoroacrylates have a structure represented by formula (2), 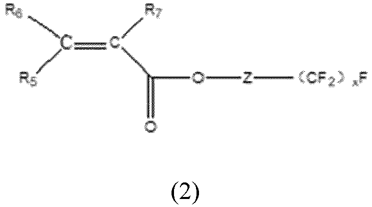 wherein Z is a linker, R₅, R₆ and R₇ are each independently selected from a group consisting of a hydrogen atom, halogen atoms, C₁-C₁₀ hydrocarbyl groups, and C₁-C₁₀ hydrocarbyl groups substituted with a halogen atom, and x is an integer of 1-20.

11. The plasma polymerized coating according to claim 10, **characterized in that** Z is a linking bond, a C₁-C₄ alkylene group, or a C₁-C₄ alkylene group with a substituent, and x is above 4.

12. The plasma polymerized coating according to claim 11, **characterized in that** R₅, R₆ and R₇ are each independently selected from a group consisting of a hydrogen atom and a methyl group.

13. The plasma polymerized coating according to claim 12, **characterized in that** the fluoroacrylates are one or more selected from a group consisting of 3-(perfluoro-5-methylhexyl)-2-hydroxypropyl methacrylate, 2-(perfluorodecyl)ethyl methacrylate, 2-(perfluorohexyl)ethyl methacrylate, 2-(perfluorododecyl)ethyl acrylate, 2-perfluorooctyl ethyl acrylate, 1H,1H,2H,2H-perfluorooctyl acrylate, 2-(perfluorobutyl)ethyl acrylate, and (perfluorocyclohexyl) methacrylate.

14. The plasma polymerized coating according to claim 1, **characterized in that** the substrate is a metal, a plastic, a fabric, glass, an electrical component, an optical instrument, or an electrical part.

15. The plasma polymerized coating according to claim 14, **characterized in that** the substrate is a glass screen.

16. A method for preparing the plasma polymerized coating according to any one of claims 1 to 15, **characterized by** comprising:
providing a substrate to place it in a plasma reactor; and introducing a vaporized reactive monomer into the plasma reactor, and performing plasma discharge, so as to carry out plasma polymerization on a surface of the substrate to form a coating.

17. The method according to claim 16, **characterized in that** the plasma is pulsed plasma.

18. The method according to claim 17, **characterized in that** the pulsed plasma is generated by applying impulsive voltage discharge with a pulse power of 10 W-300 W and a pulse duty factor of 0. 1%-80%, for a plasma discharge time of 100 seconds-36000 seconds.

19. A device, **characterized by** having the plasma polymerized coating according to any one of claims 1 to 15 on at least a part of a surface of the device.
